# EUROPÄISCHE PATENTSCHRIFT

(11) **EP 2 798 921 B1**
(45) Veröffentlichungstag und Bekanntmachung des Hinweises auf die Patenterteilung: **21.11.2018**
(21) Anmeldenummer: 12812280.1
(22) Anmeldetag: 28.12.2012
(51) Int. Cl.: H05K 5/00

(54) **GEHÄUSE ZUR AUFNAHME EINER ELEKTRONIKEINHEIT**
HOUSING FOR RECEIVING AN ELECTRONIC UNIT
BOÎTIER DESTINÉ À LOGER UNE UNITÉ ÉLECTRONIQUE

(30) Priorität: 30.12.2011 DE 102011057192
(43) Veröffentlichungstag der Anmeldung: 05.11.2014
(73) Patentinhaber: Huf Hülsbeck & Fürst GmbH & Co. KG, 42551 Velbert (DE)
(72) Erfinder: NEUHOFF, Stefan, 45239 Essen (DE); SCHINDLER, Justine, 40721 Hilden (DE)
(74) Vertreter: Vogel, Andreas
(86) Internationale Anmeldenummer: PCT/EP2012/077029
(87) Internationale Veröffentlichungsnummer: WO 2013/098377

(56) Entgegenhaltungen:
- DE-A1-102005 007 931
- US-A1- 2006 063 401

## Beschreibung

Die Erfindung betrifft ein Gehäuse zur Aufnahme einer Elektronikeinheit eines Kraftfahrzeuges, mit einem Basiselement und einem am Basiselement angeordneten Deckel, und einer Kavität, die zumindest teilweise durch das Basiselement und den Deckel bestimmt ist, wobei der Deckel die Kavität verschließt.

Aus dem Stand der Technik ist es bekannt, Elektronikeinheiten eines Kraftfahrzeuges in einem Gehäuse aufzunehmen. Das Gehäuse kann sich in einem Innenbereich des Kraftfahrzeuges befinden, der beispielsweise vor Umwelteinflüssen geschützt ist. In einigen Anwendungsfällen ist es notwendig, das Gehäuse am Außenbereich des Kraftfahrzeuges zu befestigen, so dass es "aktiv" vor Umwelteinflüssen zu schützen ist. Insbesondere ist es hierbei notwendig, dass die Elektronikeinheit, die sich in der Kavität des Gehäuses befindet, zuverlässig von Umwelteinflüssen, wie Staub, Feuchtigkeit etc. geschützt ist. In der Regel ist die Elektronikeinheit in der Kavität des Gehäuses befestigt, und zwar sowohl am Deckel als auch am Basiselement, wie zum Beispiel in der Druckschrift US 2006/063401. Nachteiligerweise hat sich gezeigt, dass aufgrund von auftretenden mechanischen Spannungen, die am Basiselement und am Deckel wirken können, Beschädigungen an der Elektronikeinheit entstehen können.

Die Druckschrift DE 102005007931 offenbart ein Gehäuse zur Aufnahme einer Elektronikeinheit wobei die Elektronikeinheit ausschließlich über den Leiterplattenkontakt am Deckel befestigt ist und mechanisch entkoppelt zum Basiselement in die Kavität sich erstreckt. Es ist Aufgabe der vorliegenden Erfindung, ein Gehäuse zu schaffen, das die oben genannten Nachteile vermeidet, insbesondere ein Gehäuse mit einer Elektronikeinheit bereitgestellt wird, wobei die Elektronikeinheit zuverlässig in der Kavität des Gehäuses gehalten ist, ohne dass die Elektronikeinheit aufgrund etwaig entstehender Spannungen am Gehäuse im Betrieb oder im eingesetzten Zustand am Kraftfahrzeug beschädigt wird. Zur Lösung dieser Aufgabe wird ein Gehäuse mit den Merkmalen des Anspruches 1 vorgeschlagen. In den abhängigen Ansprüchen sind bevorzugte Weiterbildungen ausgeführt.

Dazu ist erfindungsgemäß vorgesehen, dass die Elektronikeinheit am Deckel befestigt ist und mechanisch entkoppelt zum Basiselement ist. Hierbei erstreckt sich die Elektronikeinheit in die Kavität des Gehäuses. Der besondere Vorteil dieser Erfindung ist, dass die Elektronikeinheit lediglich am Deckel des Gehäuses unmittelbar befestigt ist, ohne das Basiselement zu berühren. Falls nun mechanische Kräfte und/oder Spannungen am Basiselement und gleichzeitig am Deckel auftreten sollten, ist es ausgeschlossen, dass die Elektronikeinheit dadurch beschädigt werden kann. Die Elektronikeinheit ist lediglich mit dem Deckel verbunden, so dass aufgrund der Entkopplung zum Basiselement die Gefahr ausgeschlossen ist, dass die Elektronikeinheit beschädigt werden kann. Der Deckel, der zum einen dafür sorgt, dass zuverlässig die Kavität vom Außenbereich des Gehäuses geschützt und verschlossen ist, hat zum anderen die Funktion eines Trägers für die Elektronikeinheit, ohne dass die Elektronikeinheit direkt mit dem Basiselement gekoppelt ist. Der Deckel weist der Kavität zugewandte Befestigungselemente auf, die die Elektronikeinheit zuverlässig halten.

Vorteilhafterweise befindet sich die Elektronikeinheit in der Kavität des Gehäuses, wobei eine direkte Kontaktierung der Elektronikeinheit mit der Innenwandung des Basiselements nicht vorliegt. Das bedeutet, dass die Elektronikeinheit kontaktlos zum Basiselement innerhalb der Kavität sich befindet. Hierbei ist es denkbar, dass die Elektronikeinheit freischwebend im Basiselement ist und zur Innenwandung des Basiselements beabstandet ist.

Vorteilhafterweise kann der Deckel außenseitig zumindest einen Steckerkontakt aufweisen, der zur Kontaktierung mit der Elektronikeinheit dient. Ebenfalls ist es denkbar, dass der Deckel zumindest zwei Steckerkontakte, insbesondere drei Steckerkontakte aufweist. Zudem kann die Erfindung mit einschließen, dass die Elektronikeinheit als Steuerung dient, die mit einem fahrzeugseitigen elektronischen Bauelement über den Steckerkontakt verbindbar ist. Beispielsweise kann vorgesehen sein, dass die Elektronikeinheit einen Sensor aufweist, der in der Lage ist ein definiertes Bewegungsmuster eines Benutzers außerhalb des Fahrzeugs zu erkennen, um insbesondere einen automatischen Öffnungsvorgang der Heckklappe oder eines Kofferraumdeckels auszulösen. Der Sensor kann zum Beispiel eine Fußbewegung des Benutzers detektieren, wodurch die Heckklappe oder der Kofferraumdeckel sich automatisch öffnet, ohne dass der Benutzer händisch einwirken muss.

In einer weiteren die Erfindung verbessernden Maßnahme kann die Elektronikeinheit kontaktlos zum Basiselement innerhalb der Kavität sich befindet. Zum Beispiel können die Befestigungselemente mit der Elektronikeinheit derart zusammenwirken, dass eine Clipsverbindung oder Rastverbindung zwischen der Elektronikeinheit und den Befestigungselementen vorliegt. Gleichzeitig wird hierdurch die Montage der Elektronikeinheit am Deckel vereinfacht.

In einer weiteren die Erfindung verbessernden Maßnahme kann der Deckel mit zwei Befestigungsarmen als Befestigungselemente ausgebildet sein, die sich in die Kavität erstrecken und die Elektronikeinheit befestigend halten. Die Befestigungsarme können zueinander parallel verlaufen und einen definierten Abstand zueinander aufweisen. Zwischen den Befestigungsarmen befindet sich die Elektronikeinheit, die durch die Befestigungsarme gehalten ist. Auch die Befestigungsarme können weitgehend kontaktlos mit der Innenwandung des Basiselementes sein. Hierbei erstrecken sich die Befestigungsarme ebenfalls, wie die Elektronikeinheit, in die Kavität des Gehäuses. In einer möglichen Ausführungsform der Erfindung hat sich gezeigt, dass es ausreichen kann, dass die Befestigungsarme durch die Kavität sich nicht vollständig erstrecken müssen, um zuverlässig die Elektronikeinheit halten zu können.

Vorteilhafterweise kann das Befestigungselement elastisch verformbar sein. Das bedeutet, dass das Befestigungselement und/oder der Befestigungsarm aufgrund seiner Werkstoffeigenschaft elastisch verformbar sind. Vorteilhafterweise können die Befestigungsarme bei der Montage der Elektronikeinheit am Deckel leicht verformt werden, bis die Elektronikeinheit ihre definierte Befestigungsstellung am Deckel erreicht hat. Anschließend können die Befestigungsarme in ihre Grundstellung sich elastisch verformen, wobei gleichzeitig in dieser Stellung der Befestigungsarme die Elektronikeinheit durch die Befestigungsarme zuverlässig fixiert ist.

Besonders vorteilhaft kann sein, dass der Deckel und/oder das Befestigungselement zumindest eines der folgenden Elemente aufweist: Rastelement, Auflagefläche, Lagerfläche, Anschlagfläche. Somit lässt sich die Elektronikeinheit an mehreren "Befestigungspunkten" bzw. an unterschiedlichen Befestigungsbereichen innerhalb der Kavität fixieren, ohne dass die Gefahr besteht, dass die Elektronikeinheit sich vom Deckel lösen kann. Die Befestigungsbereiche können unterschiedlich ausgebildet sein, wie beispielsweise als Rastelement, als Auflagefläche, Lagerfläche oder als eine Anschlagfläche.

Vorteilhafterweise kann die Elektronikeinheit eine Platine aufweisen, die über zumindest ein Kontaktelement des Steckerkontaktes mit dem Deckel befestigt ist. Zudem ist es denkbar, dass das Kontaktelement sich durch die Platine hindurcherstreckt. Das Kontaktelement kann ein metallischer Stift sein, der den Steckerkontakt mit der Platine verbindet. Beispielsweise kann das Kontaktelement mit der Platine verlötet sein, insbesondere wellenverlötet sein. Da aufgrund der erfindungsgemäßen Anordnung der Elektronikeinheit am Deckel keine Spannungen sich auf die Elektronikeinheit übertragen können, ist ein Wellenverlöten des Kontaktelementes mit der Platine möglich, welches gute Lötqualitäten erzeugen kann und gleichzeitig zu anderen konkurrierenden Lötverfahren weniger aufwendig ist.

Besonders vorteilhaft kann sein, dass der Befestigungsarm eine Auflagefläche aufweist, die innenseitig zur Platine sich befindet und die Platine an der Auflagefläche kontaktierend anliegt, insbesondere dass die Platine mit der Auflagefläche verrastet ist. Alternativ und/oder zusätzlich kann der Deckel eine Stirnwand aufweisen, die zur Kavität gerichtet ist, wobei die Stirnwand zumindest eine Auflagefläche aufweist, an der die Platine kontaktierend anliegt, insbesondere dass die Platine mit der Auflagefläche der Stirnwand verrastet ist.

Vorteilhafterweise können für die Platine zwei Befestigungsbereiche an den Auflageflächen des Befestigungsarms zur Verfügung gestellt werden sowie ein Befestigungsbereich an der Auflagefläche der Stirnfläche bereitgestellt werden, so dass die Platine zumindest an drei Befestigungsbereichen gehalten ist. Vorteilhafterweise kann der Befestigungsarm ein freies Ende mit einem Rastelement aufweisen, an dem die Platine verrastet ist. Die Rastelemente halten zusätzlich die Platine in ihrer befestigten Stellung innerhalb der Kavität.

In einer möglichen Ausführungsform der Erfindung kann die Platine zwischen der Auflagefläche des Befestigungsarmes und dem Rastelement des freien Endes des Befestigungsarms verlaufen, wobei ausgehend von der Stirnwand sich die Platine soweit in die Kavität erstreckt, dass das freie Ende der Platine beabstandet zum Rastelement des Befestigungsarms ist. In diesem Fall ist das freie Ende der Platine freischwebend. Eine zuverlässige Befestigung der Platine an den Befestigungsarmen wird dadurch erzielt, dass das Rastelement sowie die Auflagefläche der Stirnwand an einer ersten Seite der Platine anliegt und die Auflagefläche des Befestigungsarms an der zweiten Seite der Platine anliegt, wobei die Auflagefläche des Befestigungsarms ungefähr mittig zum Rastelement des freien Endes des Befestigungsarmes und der Auflagefläche der Stirnwand liegt. Somit ist die Platine in jeglicher Richtung innerhalb der Kavität unbeweglich fixiert.

Ebenfalls ist es denkbar, dass die Platine die Stirnwand kontaktiert. Alternativ und/oder zusätzlich kann das Gehäuse, insbesondere das Basiselement mit Befestigungsmitteln ausgebildet sein, so dass das Gehäuse am Kraftfahrzeug, insbesondere im Bereich oder am Stoßfängerüberzug des Kraftfahrzeuges befestigbar ist. Die Befestigungsmittel können zum Beispiel monolithisch und/oder einstückig mit dem Basiselement verbunden sein. Beispielsweise kann das Befestigungsmittel eine Öffnung darstellen, durch die ein Schraubenelement hindurchführbar ist, so dass das Gehäuse am Kraftfahrzeug verschraubt werden kann. Alternativ ist es denkbar, dass das Befestigungsmittel als Rastelement ausgebildet ist, so dass das Gehäuse am Kraftfahrzeug verclipst und/oder verrastet werden kann.

Vorteilhafterweise weist der Deckel innenseitig eine Dichtung auf, die im zusammengesetzten Zustand am Basiselement des Gehäuses eine zuverlässige Abdichtung der Kavität bewirkt.

Vorteilhafterweise kann das Kontaktelement L-förmig ausgebildet sein und in einen einseitig offenen Raum des Steckerkontakts sich erstrecken. Die geometrische Ausgestaltung des Kontaktelementes in einer L-artigen Form bewirkt, dass eine kompakte Bauform der Elektronikeinheit erzielt werden kann. Das Kontaktelement ragt an der der Platine gegenüberliegenden Seite in den offenen Raum hinein, so dass zuverlässig ein elektronischer Kontakt mit einem weiteren elektronischen Bauteil des Kraftfahrzeuges erzielbar ist. Dieser offene Raum des Steckerkontaktes kann zum Beispiel als Buchse ausgeführt sein, in die ein Stecker einsetzbar ist, wodurch ein elektrischer Kontakt zwischen der gehäuseseitigen Elektronikeinheit und einem weiteren elektronischen Bauteil, welches sich kraftfahrzeugseitig befindet, hergestellt werden kann.

Weitere Vorteile, Merkmale und Einzelheiten der Erfindung ergeben sich aus der nachfolgenden Beschreibung, in der unter Bezugnahme auf die Zeichnungen ein Ausführungsbeispiel der Erfindung im Einzelnen beschrieben ist. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Seitenansicht auf ein Gehäuse mit einer Elektronikeinheit für ein Kraftfahrzeug,
- Fig. 2: eine Schnittansicht des Gehäuses aus Figur 1,
- Fig. 3: eine vergrößerte Ansicht eines Teilbereichs aus Figur 2,
- Fig. 4: eine weitere Ansicht des Deckels des Gehäuses gemäß Figur 1, wobei der Deckel die Elektronikeinheit hält,
- Fig. 5: eine weitere Ansicht des Deckels aus Figur 4 ohne Elektronikeinheit und
- Fig. 6: eine schematische Ansicht eines Kraftfahrzeuges, an dem ein Gehäuse gemäß Figur 1 befestigt ist.

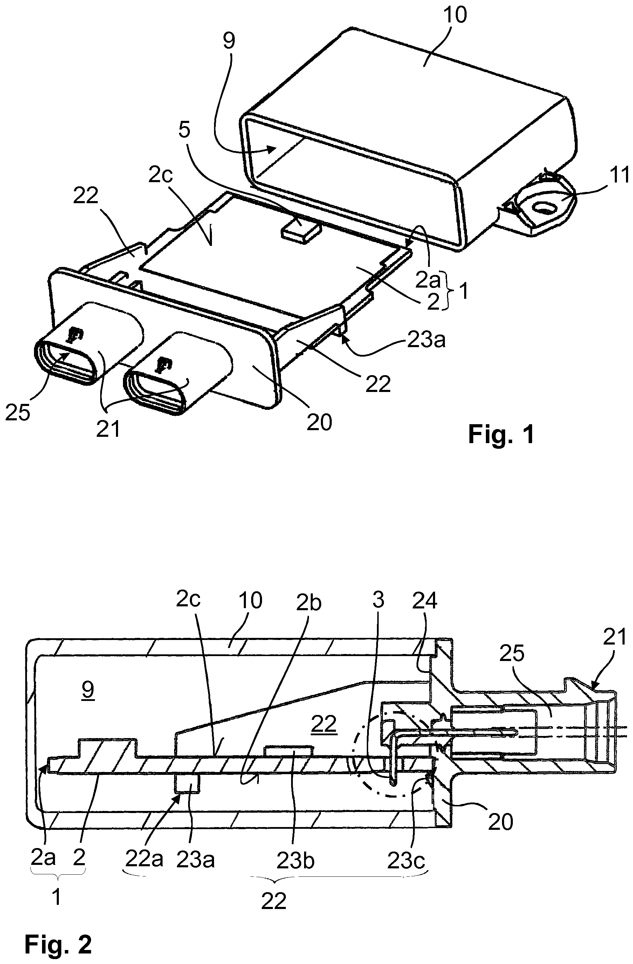

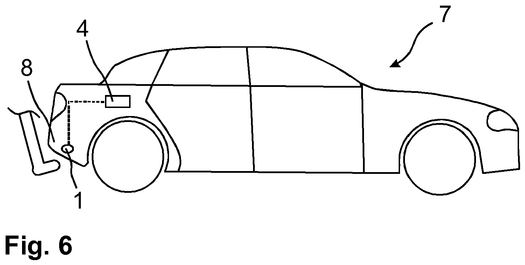

In Figur 1 ist ein Gehäuse zur Aufnahme einer Elektronikeinheit 1 gezeigt, das gemäß Figur 6 beispielsweise im Außenbereich des Kraftfahrzeuges 7 befestigbar ist. Das Gehäuse setzt sich aus einem Basiselement 10 und einem Deckel 20 zusammen, wobei durch das Basiselement 10 und den Deckel 20 eine Kavität 9 bestimmt ist, in der sich die Elektronikeinheit 1 befindet. Der Deckel 20 verschließt abdichtend die Kavität 9, so dass Umwelteinflüsse, wie Feuchtigkeit, Staub etc. nicht in die Kavität 9 gelangen können. Somit wird die Elektronikeinheit 1 wirkungsvoll geschützt.

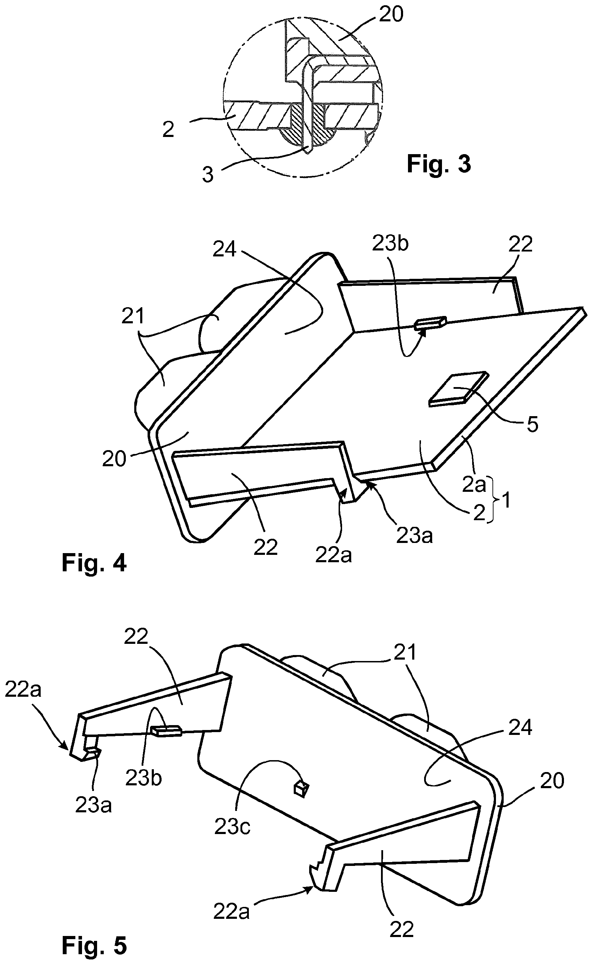

Wie auch in Figur 2 und Figur 4 deutlich zu erkennen ist, ist die Elektronikeinheit 1 am Deckel 20 befestigt. Der Deckel 20 weist eine Stirnwand 24 auf, die zur Kavität 9 gerichtet ist und somit innenseitig der Kavität 9 sich befindet. Der Deckel 20 weist zwei Befestigungsarme 22 auf, die als Befestigungselemente wirken. Beide Befestigungsarme 22 verlaufen parallel zueinander und erstrecken sich in die Kavität 9. Zudem sind die Befestigungsarme 22 elastisch verformbar ausgebildet, damit die Elektronikeinheit 1 zuverlässig in ihre befestigte Position gemäß Figur 4 gebracht werden kann, worauf im Folgenden noch eingegangen wird.

Außenseitig weist der Deckel 20 zwei Steckerkontakte 21 auf, die zur Kontaktierung mit der Elektronikeinheit 1 dienen. Jeder Befestigungsarm 22 weist eine Auflagefläche 23b auf, an der die Elektronikeinheit 1 mit ihrer Platine 2 anliegt. Die Stirnwand 24 weist zudem eine Auflagefläche 23c auf, auf der ebenfalls die Platine 2 aufliegt, wobei gleichzeitig die Platine 2 die Stirnwand 24 kontaktieren kann.

Zudem weist jeder Befestigungsarm 22 ein freies Ende 22a auf, welches mit einem Rastelement 23a ausgebildet ist, an dem die Platine 2 verrastet ist.

Somit ist die Platine 2 an mehreren Befestigungsbereichen 23a, 23b, 23c des Deckels 20, insbesondere des Befestigungsarms 22 fixiert, ohne dass die Gefahr besteht, dass sich die Elektronikeinheit 1 vom Deckel 20 lösen kann.

Gemäß des Ausführungsbeispiels verläuft die Platine 2 zwischen der Auflagefläche 23b des Befestigungsarmes 22 und dem Rastelement 23a des freien Endes 22a des Befestigungsarmes 22. Gleichzeitig liegt das Rastelement 23a auf ungefähr der gleichen Höhe zur Auflagefläche 23c der Stirnwand 24. Somit ist die Platine 2 nach unten und nach oben durch die Auflageflächen 23b, 23c fixiert. Ferner verhindert das Rastelement 23a, dass sich die Platine 2 vom Deckel 20, insbesondere von der Stirnwand 24 löst. Die Platine 2 weist des Weiteren entsprechende Gegenrastmittel auf, an denen das Rastelement 23a eingreift, wodurch eine zuverlässige Rastverbindung zwischen der Platine 2 und dem Rastelement 23a des freien Endes 22a des Befestigungsarmes 22 entsteht.

Wie in Figur 4 zu erkennen ist, liegt das Rastelement 23a sowie die Auflagefläche 23c der Stirnwand 24 an einer ersten Seite 2b der Platine 2 an. Die Auflagefläche 23b des Befestigungsarmes 22 liegt hingegen an der zweiten Seite 2c der Platine 2 an. Die Auflagefläche 23b des Befestigungsarmes 22 liegt zwischen dem Rastelement 23a und der Auflagefläche 23c der Stirnwand 24.

Wie in Figur 2 besonders verdeutlicht ist, ist die Elektronikeinheit 1 mit ihrer Platine 2 lediglich am Deckel 20 befestigt und somit mechanisch entkoppelt zum Basiselement 10. Das bedeutet, dass sich die Elektronikeinheit 1 zwar in die Kavität 9 erstreckt, jedoch freischwebend im Basiselement 10 sich befindet. Es besteht kein direkter Kontakt zwischen der Platine 2 und der Innenwandung des Basiselementes 10. Falls Spannungen am Gehäuse, insbesondere am Basiselement 10 und am Deckel 20 auftreten sollten, wird wirkungsvoll verhindert, dass die Elektronikeinheit 1 dadurch beschädigt werden kann. Die Spannungen können durch den Deckel 20 aufgenommen werden, ohne schädigende Auswirkungen auf die Elektronikeinheit 1.

Wie in Figur 3 verdeutlicht ist, erstreckt sich das Kontaktelement 3 durch die Platine 2, wobei das Kontaktelement 3 mit der Platine 2 verlötet ist. Im vorliegenden Ausführungsbeispiel handelt es sich um ein wellenverlötetes Kontaktelement 3.

Figur 1 zeigt zudem, dass die Elektronikeinheit 1 mit einem Mikrocontroller 5 sowie darin integrierten Sensor 5 ausgeführt ist, der im vorliegenden Ausführungsbeispiel in der Lage ist ein definiertes Bewegungsmuster eines Benutzers außerhalb des Fahrzeuges 7 zu erkennen. Gemäß Figur 6 ist angedeutet, dass der Sensor 5 eine definierte Fußbewegung unterhalb des Stoßfängerüberzuges 8 erkennen kann, um einen automatischen Öffnungsvorgang der Heckklappe 6 des Kraftfahrzeuges 7 auszulösen.

Wie in Figur 2 gezeigt ist, erstreckt sich das Kontaktelement 3 von der Platine 2 aus durch den Deckel 20 in einen einseitig offenen Steckerinnenraum 25 des Steckerkontaktes 21. Dieser Raum 25 dient als Buchse, um einen kraftfahrzeugseitigen Stecker daran anzuschließen. Im vorliegenden Ausführungsbeispiel ist das Kontaktelement L-förmig ausgebildet, wodurch das Gehäuse sowie die Gesamtkonstruktion kompakt gehalten werden kann.

Zudem ist in Figur 6 ein elektronisches Bauelement 4 gezeigt, welches elektrisch/elektronisch mit der Elektronikeinheit 1 des Gehäuses gemäß Figur 1 verbunden ist. Im vorliegenden Ausführungsbeispiel dient die Elektronikeinheit 1 als Steuerung, die mit dem fahrzeugseitigen elektronischen Bauelement 4 über den Steckerkontakt 21 verbunden ist. Wie in Figur 1 zudem gezeigt ist, weist das Basiselement 10 außenseitig zwei Befestigungsmittel 11 auf, an denen das Gehäuse am Fahrzeug 7 fixiert werden kann, beispielsweise über eine Schraubenverbindung. Alternativ ist es denkbar Rastelemente als Befestigungsmittel 11 außenseitig am Basiselement 10 vorzusehen, so dass das Gehäuse über eine Verclipsung oder Verrastung am Kraftfahrzeug 7 befestigbar ist.

Im vorliegenden Ausführungsbeispiel gemäß Figur 5 bildet der Deckel 20 mit dem Steckerkontakt 21 und den Befestigungsarmen 22 ein monolithisches Bauteil aus Kunststoff.

### Bezugszeichenliste

- 1: Elektronikeinheit
- 2: Platine
- 2a: freies Ende der Platine
- 2b: erste Seite der Platine
- 2c: zweite Seite der Platine
- 3: Kontaktelement
- 4: elektronisches Bauelement
- 5: Sensor, Mikrocontroller
- 6: Kofferraum
- 7: Kraftfahrzeug
- 8: Stoßfängerüberzug
- 9: Kavität

- 10: Basiselement
- 11: Befestigungsmittel

- 20: Deckel
- 21: Steckerkontakt
- 22: Befestigungselement, Befestigungsarm
- 22a: freies Ende
- 23a: Rastelement
- 23b: Auflagefläche, Lagerfläche
- 23c: Auflagefläche, Lagerfläche, Rastelement, Rasthaken
- 24: Stirnwand
- 25: Raum, Steckerinnenraum

## Patentansprüche

1. Gehäuse zur Aufnahme einer Elektronikeinheit (1) eines Kraftfahrzeuges (7), mit einem Basiselement (10) und einem am Basiselement (10) angeordneten Deckel (20), einer Kavität (9), die zumindest teilweise durch das Basiselement (10) und den Deckel (20) bestimmt ist, wobei der Deckel (20) die Kavität (9) verschließt und der Kavität (9) zugewandte Befestigungselemente (22) aufweist, die die Elektronikeinheit (1) zuverlässig halten, und die Elektronikeinheit (1) am Deckel (20) befestigt ist,
**dadurch gekennzeichnet,**
**dass** die Elektronikeinheit (1) mechanisch entkoppelt zum Basiselement (10) in die Kavität (9) sich erstreckt.

2. Gehäuse nach Anspruch 1,
**dadurch gekennzeichnet,**
**dass** der Deckel (20) außenseitig zumindest einen Steckerkontakt (21) aufweist, der zur Kontaktierung mit der Elektronikeinheit (1) dient.

3. Gehäuse nach Anspruch 1 oder 2,
**dadurch gekennzeichnet,**
**dass** die Elektronikeinheit (1) freischwebend im Basiselement (10) sich befindet.

4. Gehäuse nach einem der vorgenannten Ansprüche,
**dadurch gekennzeichnet,**
**dass** die Elektronikeinheit (1) kontaktlos zum Basiselement (10) innerhalb der Kavität (9) sich befindet und/oder insbesondere der Deckel (20) mit zwei Befestigungsarmen (22) als Befestigungselemente ausgebildet ist, die sich in die Kavität (9) erstrecken und die Elektronikeinheit (1) befestigend halten.

5. Gehäuse nach einem der vorgenannten Ansprüche,
**dadurch gekennzeichnet,**
**dass** das Befestigungselement (22) elastisch verformbar ist.

6. Gehäuse nach einem der vorgenannten Ansprüche,
**dadurch gekennzeichnet,**
**dass** der Deckel (20) und/oder das Befestigungselement (22) zumindest eines der folgenden Elemente aufweist: Rastelement, Auflagefläche, Lagerfläche, Anschlagfläche.

7. Gehäuse nach einem der vorgenannten Ansprüche,
**dadurch gekennzeichnet,**
**dass** die Elektronikeinheit (20) eine Platine (2) aufweist, die über zumindest ein Kontaktelement (3) des Steckerkontaktes (21) mit dem Deckel (20) befestigt ist, wobei insbesondere das Kontaktelement (3) sich durch die Platine (2) hindurcherstreckt und/oder das Kontaktelement (3) mit der Platine (2) verlötet ist, insbesondere wellenverlötet ist.

8. Gehäuse nach einem der vorgenannten Ansprüche,
**dadurch gekennzeichnet,**
**dass** die Elektronikeinheit (1) als Steuerung dient, die mit einem fahrzeugseitigen elektronischen Bauelement (4) über den Steckerkontakt (21) verbindbar ist.

9. Gehäuse nach einem der vorgenannten Ansprüche,
**dadurch gekennzeichnet,**
**dass** die Elektronikeinheit (1) einen Sensor (5) aufweist, der in der Lage ist ein definiertes Bewegungsmuster eines Benutzers außerhalb des Fahrzeugs (7) zu erkennen, um insbesondere einen automatischen Öffnungsvorgang und/oder Schließvorgang der Heckklappe (6) oder eines Kofferraumdeckels (6) auszulösen.

10. Gehäuse nach einem der vorgenannten Ansprüche,
**dadurch gekennzeichnet,**
**dass** der Befestigungsarm (22) eine Auflagefläche (23b) aufweist, die innenseitig zur Platine (2) sich befindet und die Platine (2) an der Auflagefläche (23b) kontaktierend anliegt, insbesondere dass die Platine (2) mit der Auflagefläche (23b) verrastet ist.

11. Gehäuse nach einem der vorgenannten Ansprüche,
**dadurch gekennzeichnet,**
**dass** der Deckel (20) eine Stirnwand (24) aufweist, die zur Kavität (9) gerichtet ist, wobei die Stirnwand (24) eine Auflagefläche (23c) aufweist, an der die Platine (9) kontaktierend anliegt, insbesondere dass die Platine (9) mit der Auflagefläche (23c) der Stirnwand (24) verrastet ist.

12. Gehäuse nach einem der vorgenannten Ansprüche,
**dadurch gekennzeichnet,**
**dass** die Platine (2) die Stirnwand (24) kontaktiert.

13. Gehäuse nach einem der vorgenannten Ansprüche,
**dadurch gekennzeichnet,**
**dass** das Gehäuse, insbesondere das Basiselement (10) mit Befestigungsmitteln (11) ausgebildet ist, so dass das Gehäuse am Kraftfahrzeug (7), insbesondere im Bereich oder am Stoßfängerüberzug (8) des Kraftfahrzeuges (7) befestigbar ist.

14. Gehäuse nach einem der vorgenannten Ansprüche,
**dadurch gekennzeichnet,**
**dass** der Befestigungsarm (22) ein freies Ende (22a) mit einem Rastelement (23a) aufweist, an dem die Platine (2) verrastet ist und/oder dass der Deckel (20) zumindest zwei Steckerkontakte (21), insbesondere drei Steckerkontakte (21) aufweist.

15. Gehäuse nach einem der vorgenannten Ansprüche,
**dadurch gekennzeichnet,**
**dass** die Platine (2) zwischen der Auflagefläche (23b) des Befestigungsarmes (22) und dem Rastelement (23a) des freien Endes (23a) des Befestigungsarms (22) verläuft, wobei ausgehend von der Stirnwand (24) sich die Platine (2) soweit in die Kavität (9) erstreckt, dass das freie Ende (2a) der Platine (2) beabstandet zum Rastelement (23a) des Befestigungsarms (22) ist.

16. Gehäuse nach einem der vorgenannten Ansprüche,
**dadurch gekennzeichnet,**
**dass** das Rastelement (23a) sowie die Auflagefläche (23c) der Stirnwand (24) an einer ersten Seite (2b) der Platine (2) anliegt und die Auflagefläche (23b) des Befestigungsarms (22) an der zweiten Seite (2c) der Platine (2) anliegt, wobei die Auflagefläche (23b) des Befestigungsarms (22) circa mittig zum Rastelement (23a) des freien Endes (22a) des Befestigungsarmes (22) und der Auflagefläche (23c) der Stirnwand (24) liegt.

17. Gehäuse nach einem der vorgenannten Ansprüche,
**dadurch gekennzeichnet,**
**dass** das Kontaktelement (3) L-förmig ausgebildet ist und in einen einseitig offenen Raum (25) des Steckerkontakts (21) sich erstreckt.

## Claims

1. A housing for receiving an electronic unit (1) of a motor vehicle (7), having a base element (10) and a cover (20) arranged on the base element (10), a cavity (9), which is at least partially determined by the base element (10) and the cover (20), wherein the cover (20) closes the cavity (9) and comprises fastening elements (22) which face the cavity (9) and reliably hold the electronic unit (1), and the electronic unit (1) is fastened to the cover (20), **characterized in that**
the electronic unit (1) extends into the cavity (9) mechanically decoupled from the base element (10).

2. The housing according to claim 1,
**characterized in that**
the cover (20) comprises at least one plug contact (21) at the exterior side, which serves for the contacting with the electronic unit (1).

3. The housing according to claim 1 or 2,
**characterized in that**
the electronic unit (1) is located in the base element (10) in a free-floating manner.

4. The housing according to one of the preceding claims,
**characterized in that**
the electronic unit (1) is located inside the cavity (9) contactless to the base element (10) and/or in particular the cover (20) is configured with two fastening arms (22) as fastening elements, which extent into the cavity (9) and hold the electronic unit (1) in a fastening manner.

5. The housing according to one of the preceding claims,
**characterized in that**
the fastening element (22) is elastically deformable.

6. The housing according to one of the preceding claims,
**characterized in that**
the cover (20) and/or the fastening element (22) comprises at least one of the following elements: latch element, contact support, support surface, stop surface.

7. The housing according to one of the preceding claims,
**characterized in that**
the electronic unit (20) comprises a circuit board (2), which is fastened to the cover (20) via at least one contact element (3) of the plug contact (21), wherein the contact element (3) in particular extends through the circuit board (2) and/or the contact element (3) is soldered, in particular wave-soldered, to the circuit board (2).

8. The housing according to one of the preceding claims,
**characterized in that**
the electronic unit (1) serves as a control, which is connectable to a vehicle-side electronic component (4) via the plug contact (21).

9. The housing according to one of the preceding claims,
**characterized in that**
the electronic unit (1) comprises a sensor (5), which is capable to detect a defined movement pattern of a user outside the vehicle (7) in order to in particular trigger an automatic opening process and/or closing process of the tailgate (6) or of a trunk deck (6).

10. The housing according to one of the preceding claims,
**characterized in that**
the fastening arm (22) comprises a support surface (23b), which is located internally to the circuit board (2) and the circuit board (2) bears against the support surface (23b) in a contacting manner, in particular that the circuit board (2) is latched with the support surface (23b).

11. The housing according to one of the preceding claims,
**characterized in that**
the cover (20) comprises a face wall (24), which faces the cavity (9), wherein the face wall (24) comprises a support surface (23c), on which the circuit board (9) bears in a contacting manner, in particular **in that** the circuit board (9) is latched with the support surface (23c) of the face wall (24).

12. The housing according to one of the preceding claims,
**characterized in that**
the circuit board (2) contacts the face wall (24).

13. The housing according to one of the preceding claims,
**characterized in that**
the housing, in particular the base element (10), is configured with fastening means (11), so that the housing can be fastened to the motor vehicle (7), in particular in the region or at the bumper cover (8) of the motor vehicle (7).

14. The housing according to one of the preceding claims,
**characterized in that**
the fastening arm (22) comprises a free end (22a) with a latch element (23a), on which the circuit board (2) is latched and/or **in that** the cover (20) comprises at least two plug contacts (21), in particular three plug contacts (21).

15. The housing according to one of the preceding claims,
**characterized in that**
the circuit board (2) extends between the support surface (23b) of the fastening arm (22) and the latch element (23a) of the free end (23a) of the fastening arm (22), wherein starting from the face wall (24) the circuit board (2) extends into the cavity (9) far enough that the free end (2a) of the circuit board (2) is spaced from the latch element (23a) of the fastening arm (22).

16. The housing according to one of the preceding claims,
**characterized in that**
the latch element (23a) as well as the support surface (23c) of the face wall (24) rests against a first side (2b) of the circuit board (2) and the support surface (23b) of the fastening arm (22) rests against the second side (2c) of the circuit board (2), wherein the support surface (23b) of the fastening arm (22) lies approximately centrally in relation to the latch element (23a) of the free end (22a) of the fastening arm (22) and the support surface (23c) of the face wall (24).

17. The housing according to one of the preceding claims,
**characterized in that**
the contact element (3) is formed L-shaped and extends into a space (25) of the plug contact (21) open at one side.

## Revendications

1. Boîtier destiné à loger une unité électronique (1) d'un véhicule automobile (7) comprenant un élément de base (10) et un couvercle (20) disposé sur l'élément de base (10), une cavité (9) qui est définie au moins en partie par l'élément de base (10) et le couvercle (20), ledit couvercle (20) fermant la cavité (9) et comprenant des éléments de fixation (22) tournés vers la cavité (9) qui maintiennent l'unité électronique (1) de manière sûre, et l'unité électronique (1) étant fixée sur le couvercle (20), **caractérisé en ce que** l'unité électronique (1) s'étend découplée mécaniquement de l'élément de base (10) dans la cavité (9).

2. Boîtier selon la revendication 1, **caractérisé en ce que** le couvercle (20) comporte du côté extérieur au moins un contact de connexion (21) qui sert à la mise en contact avec l'unité électronique (1).

3. Boîtier selon la revendication 1 ou 2, **caractérisé en ce que** l'unité électronique (1) se trouve de manière suspendue dans l'élément de base (10).

4. Boîtier selon l'une quelconque des revendications précédentes, **caractérisé en ce que** l'unité électronique (1) se trouve à l'intérieur de la cavité (9), sans être en contact avec l'élément de base (10), et/ou **en ce que** le couvercle (20) en particulier avec deux bras de fixation (22) est réalisé sous forme d'éléments de fixation qui s'étendent dans la cavité (9) et maintiennent l'unité électronique (1) de manière fixant.

5. Boîtier selon l'une quelconque des revendications précédentes, **caractérisé en ce que** l'élément de fixation (22) peut être élastiquement déformé.

6. Boîtier selon l'une quelconque des revendications précédentes, **caractérisé en ce que** le couvercle (20) et/ou l'élément de fixation (22) comporte au moins l'un des éléments suivants : élément d'encliquetage, surface portant, surface d'appui, surface de butée.

7. Boîtier selon l'une quelconque des revendications précédentes, **caractérisé en ce que** l'unité électronique (20) comporte une platine (2) qui est fixée au couvercle (20) au moyen d'au moins un élément de contact (3) du contact de connexion (21), ledit élément de contact (3) en particulier s'étendant à travers la platine (2) et/ou l'élément de contact (3) étant brasé à la platine (2), plus spécifiquement brasé à la vague.

8. Boîtier selon l'une quelconque des revendications précédentes, **caractérisé en ce que** l'unité électronique (1) est utilisée comme une commande qui peut être reliée avec un élément de construction (4) électronique côté véhicule au moyen du contact de connexion (21).

9. Boîtier selon l'une quelconque des revendications précédentes, **caractérisé en ce que** l'unité électronique (1) comporte un capteur (5) qui est capable de reconnaître un schéma défini de mouvements d'un utilisateur en-dehors du véhicule automobile (7) afin de déclencher plus spécifiquement un processus d'ouverture automatique et/ou un processus de fermeture du hayon arrière (6) ou d'un capot de coffre (6).

10. Boîtier selon l'une quelconque des revendications précédentes, **caractérisé en ce que** le bras de fixation (22) comporte une surface portant (23b) qui se trouve du côté intérieur par rapport à la platine (2) et **en ce que** la platine (2) est en appui contre la surface d'appui (23b) de manière d'être en contact, plus spécifiquement **en ce que** la platine (2) est encliquetée avec la surface d'appui (23b).

11. Boîtier selon l'une quelconque des revendications précédentes, **caractérisé en ce que** le couvercle (20) comporte une paroi frontale (24) qui est tournée vers la cavité (9), ladite paroi frontale (24) comportant une surface d'appui (23c) contre laquelle la platine (9) est en appui de manière á être en contact en contact, ladite platine (9) en particulier étant encliquetée avec la surface d'appui (23c) avec la paroi frontale (24).

12. Boîtier selon l'une quelconque des revendications précédentes, **caractérisé en ce que** la platine (2) est en contact avec la paroi frontale (24).

13. Boîtier selon l'une quelconque des revendications précédentes, **caractérisé en ce que** le boîtier, plus spécifiquement l'élément de base (10) avec des moyens de fixation (11), est conçu de telle sorte que le boîtier peut être fixé sur le véhicule automobile (7), plus spécifiquement dans la zone ou sur le revêtement du pare-chocs (8) du véhicule automobile (7).

14. Boîtier selon l'une quelconque des revendications précédentes, **caractérisé en ce que** le bras de fixation (22) comporte une extrémité libre (22a) avec un élément d'encliquetage (23a) sur lequel la platine (2) est encliquetée et/ou **en ce que** le couvercle (20) comporte au moins deux contacts de connexion (21), plus spécifiquement trois contacts de connexion (21).

15. Boîtier selon l'une quelconque des revendications précédentes, **caractérisé en ce que** la platine (2) s'étend entre la surface d'appui (23b) du bras de fixation (22) et l'élément d'encliquetage (23a) de l'extrémité libre (23a) du bras de fixation (22), la platine (2) s'étendant dans la cavité (9) depuis la paroi frontale (24) de telle sorte que l'extrémité libre (2a) de la platine (2) est espacée par rapport à l'élément d'encliquetage (23a) du bras de fixation (22).

16. Boîtier selon l'une quelconque des revendications précédentes, **caractérisé en ce que** l'élément d'encliquetage (23a) ainsi que la surface d'appui (23c) de la paroi frontale (24) sont en appui contre un premier côté (2b) de la platine (2) et la surface d'appui (23b) du bras de fixation (22) contre le deuxième côté (2c) de la platine (2), la surface d'appui (23b) du bras de fixation (22) se trouvant approximativement au milieu de l'élément d'encliquetage (23a) de l'extrémité libre (22a) du bras de fixation (22) et de la surface d'appui (23c) de la paroi frontale (24).

17. Boîtier selon l'une quelconque des revendications précédentes, **caractérisé en ce que** l'élément de contact (3) est réalisé en forme de L et s'étend dans un espace (25) ouvert d'un côté du contact de connexion (21).
